# EUROPÄISCHE PATENTSCHRIFT

(11) **EP 1 476 939 B1**
(45) Veröffentlichungstag und Bekanntmachung des Hinweises auf die Patenterteilung: **13.07.2005**
(21) Anmeldenummer: 03704300.7
(22) Anmeldetag: 07.02.2003
(51) Int. Cl.: H03C 3/09

(54) **VERFAHREN ZUM ABGLEICHEN EINES ZWEI-PUNKT-MODULATORS UND ZWEI-PUNKT-MODULATOR MIT EINER ABGLEICHVORRICHTUNG**
METHOD FOR ADJUSTING A TWO-LEVEL MODULATOR AND TWO-LEVEL MODULATOR WITH AN ADJUSTING DEVICE
PROCEDE D'EQUILIBRAGE D'UN SYSTEME DE MODULATION A DEUX NIVEAUX ET SYSTEME DE MODULATION A DEUX NIVEAUX EQUIPE D'UN DISPOSITIF D'EQUILIBRAGE

(30) Priorität: 22.02.2002 DE 10207544
(43) Veröffentlichungstag der Anmeldung: 17.11.2004
(73) Patentinhaber: Infineon Technologies AG, 81669 München (DE)
(72) Erfinder: HAMMES, Markus, 46539 Dinslaken (DE); VAN WAASEN, Stefan, S-19248 Sollentuna (SE); LI PUMA, Giuseppe, 44791 Bochum (DE)
(74) Vertreter: Lange, Thomas, Dr.
(86) Internationale Anmeldenummer: PCT/DE2003/000370
(87) Internationale Veröffentlichungsnummer: WO 2003/073601

(56) Entgegenhaltungen:
- EP-A- 0 961 412
- WO-A-99/07065
- GB-A- 2 337 884
- GB-A- 2 354 649
- US-A- 5 207 491
- US-B1- 6 229 400

## Beschreibung

Die Erfindung bezieht sich auf ein Verfahren zum Abgleichen eines Zwei-Punkt-Modulators, welcher auf einer PLL-Schaltung basiert. Ferner betrifft die Erfindung einen Zwei-Punkt-Modulator mit einer Abgleichvorrichtung.

Eine aufwandsarme Realisierung eines Senderkonzepts für Transceiver in Mobilfunksystemen bieten Sender, welche einen nach dem bekannten Prinzip der Zwei-Punkt-Modulation arbeitenden Modulator aufweisen. Eine PLL (phase locked loop = Nachlaufsynchronisations)-Schaltung wird dabei als Frequenzsynthesizer eingesetzt und zur Phasen- oder Frequenzmodulation eines hochfrequenten Signals genutzt.

Das Einprägen der Modulationssignale erfolgt üblicherweise an zwei Punkten der PLL-Schaltung. Zum einen wird ein programmierbarer Frequenzteiler der PLL-Schaltung durch ein digitales Modulationssignal angesteuert. Der programmierbare Frequenzteiler ist im Rückkoppelzweig der PLL-Schaltung angebracht und repräsentiert einen Punkt der PLL-Schaltung, an welchem sich für das Einprägen einer Modulation ein Tiefpassübertragungsverhalten ergibt. Das digitale Modulationssignal kann dabei eine größere Bandbreite aufweisen als der durch die PLL-Schaltung gebildete Tiefpass. Zum anderen wird in einen im Vorwärtszweig der PLL-Schaltung liegenden Summationspunkt, welcher vorzugsweise dem spannungsgesteuerten Oszillator vorgeschaltet ist, ein analoges Modulationssignal eingekoppelt. Die an dem Summationspunkt eingespeiste analoge Modulation wirkt mit einer Hochpassfilterung durch die geschlossene Regelschleife auf den Ausgang der PLL-Schaltung, womit das entsprechende Modulationssignal wiederum durch das Übertragungsverhalten verfälscht wird. Das digitale und das analoge Modulationssignal überlagern sich am Ausgang der PLL-Schaltung, und es ergibt sich auf diese Weise ein frequenzunabhängiges Übertragungsverhalten der PLL-Schaltung. Das gleichzeitige Einprägen eines digitalen und eines analogen Modulationssignals in eine PLL-Schaltung wird als Zwei-Punkt-Modulation bezeichnet.

Ein derartiger Zwei-Punkt-Modulator sowie ein Verfahren zur Phasen- oder Frequenzmodulation-mit einer PLL-Schaltung ist ein der deutschen Offenlegungsschrift DE 199 29 167 A1 beschrieben. Ein digitales Modulationssignal wird in den Steueranschluss eines Frequenzteilers im Rückkoppelzweig der PLL-Schaltung eingespeist, wodurch die Zahl bestimmt wird, mit deren Kehrwert die Momentanfrequenz des Eingangssignals des Frequenzteilers multipliziert wird. Ferner wird das digitale Modulationssignal mittels eines Digital-Analog-Wandlers in ein analoges Modulationssignal umgewandelt, welches an einem einen Hochpasspunkt repräsentierenden Summationspunkt in die PLL-Schaltung eingekoppelt wird.

Ein Zwei-Punkt Modulator ist auch aus dem Dokument WO 99 070 65 A bekannt. In diesem Modulator ist einem Hauptpfad der PLL-Schaltung ein Abgleichpfad parallel geschaltet.

Bei der beschriebenen Art des Senderkonzepts bleibt die Regelschleife geschlossen. Um ein geringes Rauschen der PLL-Schaltung zu erzielen, wird die Bandbreite der PLL-Schaltung deutlich kleiner ausgelegt, als es für die Übertragung der modulierten Daten erforderlich wäre. Zur Kompensation der geringen Bandbreite wird neben dem digitalen Modulationssignal das analoge Modulationssignal in die PLL-Schaltung eingekoppelt.

Wesentlich für die Funktionsweise der Zwei-Punkt-Modulation ist, dass das digitale Modulationssignal und das analoge Modulationssignal neben einer zeitlichen Gleichphasigkeit ein hohes Maß an Übereinstimmung ihrer Amplituden aufweisen. Aufgrund von Herstellungstoleranzen der für die analoge Modulation notwendigen Komponenten treten jedoch Schwankungen in der Modulationssteilheit sowie der Amplitudenhöhe des analogen Modulationssignals auf. Aus diesem Grund ist es erforderlich, nach der Herstellung der PLL-Schaltung einen Amplitudenabgleich zwischen dem analogen und dem digitalen Modulationssignal durchzuführen.

Sollen zudem Temperatureinflüsse berücksichtigt werden, muss ein derartiger Abgleich vor jedem Sendevorgang durchgeführt werden.

Ein bekanntes Verfahren zum Abgleichen einer PLL-Schaltung mit Zwei-Punkt-Modulation besteht darin, die Zwei-Punkt-Modulation der Schaltung im eingeschwungenen Zustand aufzuprägen und mit einem externen Messempfänger das ausgesendete Signal zu empfangen und zu demodulieren. In Abhängigkeit von dem erhaltenen Demodulationsergebnis wird ein Abgleich der digitalen und analogen Modulationssignale vorgenommen. Aufgrund des nicht-linearen Verhaltens des schwingungserzeugenden Glieds der PLL-Schaltung - eines spannungsgesteuerten Oszillators (englisch: voltage controlled oscillator; VCO) - hinsichtlich der Frequenz als Funktion der Steuerspannung, muss dieser Abgleich jedoch für jeden Kanal vorgenommen werden. Für eine größere Anzahl an Kanälen resultiert daraus eine entsprechend lange Messdauer. Zusätzlich müssen die Abgleichinformationen in einem Speicher abgelegt werden. Ein weiterer Nachteil dieses Verfahrens ist, dass der Einfluss von Temperaturänderungen bei diesem Verfahren nicht berücksichtigt wird.

Ein weiteres bekanntes Verfahren zum Abgleichen einer PLL-Schaltung mit Zwei-Punkt-Modulation basiert im Wesentlichen auf dem vorstehend beschriebenen Verfahren. Jedoch wird hierbei der Empfang sowie die Demodulation des von der PLL-Schaltung erzeugten Signals von dem Empfangsteil des Transceivers durchgeführt. Dies bedingt jedoch einen wesentlich höheren Schaltungsaufwand, da für die Realisierung dieses Verfahrens eine zweite PLL-Schaltung im Empfänger erforderlich ist.

Aufgabe der Erfindung ist es daher, ein Abgleichverfahren für einen auf einer PLL-Schaltung basierenden Zwei-Punkt-Modulator anzugeben, mit dem ein schneller, genauer sowie kostengünstiger Amplitudenabgleich zwischen dem digitalen und dem analogen Modulationssignal erreicht werden kann. Des Weiteren soll ein Zwei-Punkt-Modulator mit einer PLL-Schaltung und einer Abgleichvorrichtung geschaffen werden, mittels der ein schneller und genauer Amplitudenabgleich der Modulationssignale mit einem relativ geringen Schaltungsaufwand erzielt werden kann.

Die der Erfindung zugrunde liegende Aufgabenstellung wird durch die Merkmale der unabhängigen Patentansprüche 1 und 10 gelöst. Vorteilhafte Weiterbildungen und Ausgestaltungen der Erfindung sind in den Unteransprüchen angegeben.

Bei einem erfindungsgemäßen Abgleichverfahren für eine nach dem Prinzip der Zwei-Punkt-Modulation arbeitende PLL-Schaltung wird die PLL-Schaltung durch das Einprägen eines digitalen Modulationssignals auf eine erste Frequenz eingeregelt. Anschließend wird das digitale Modulationssignal deaktiviert, d.h. auf den Wert Null gesetzt, wodurch die PLL-Schaltung auf eine von der ersten Frequenz abweichende zweite Frequenz einregelt. Ein Differenzsignal, welches charakteristisch für eine Änderung eines Steuersignals einer frequenzerzeugenden Einheit der PLL-Schaltung ist, wobei die Änderung durch das Deaktivieren des digitalen Modulationssignals bewirkt wird, wird erzeugt und aus der PLL-Schaltung ausgekoppelt. Das Differenzsignal wird mit einem Vergleichssignal, welches charakteristisch für einen Modulationshub eines analogen Modulationssignals ist, verglichen, und in Abhängigkeit von der bei dem Vergleich ermittelten Abweichung wird der Modulationshub des analogen Modulationssignals derart geändert, dass die Abweichung beseitigt wird.

Das erfindungsgemäße Abgleichverfahren weist den Vorteil auf, dass keine Demodulation des von der PLL-Schaltung erzeugten Ausgangssignals zu Abgleichzwecken durchgeführt werden muss. Ferner ist der Schaltungsaufwand zur Realisierung des erfindungsgemäßen Abgleichverfahrens relativ gering. Im Ergebnis ergibt sich folglich ein schnelles und genaues Abgleichverfahren für einen Zwei-Punkt-Modulator, welches zudem kostengünstig realisiert werden kann.

Gemäß einer vorteilhaften Ausgestaltung der Erfindung wird das digitale Modulationssignal in die PLL-Schaltung derart eingeprägt, dass die PLL-Schaltung auf eine erste Frequenz einregelt, welche durch das Subtrahieren einer Frequenz eines variabel wählbaren, digitalen Modulationshubs von einer Kanalmittenfrequenz gebildet ist. Vorzugsweise wird durch das Deaktivieren des digitalen Modulationssignals die PLL-Schaltung auf eine zweite Frequenz eingeregelt, die gleich der Kanalmittenfrequenz ist.

Eine bevorzugte Ausgestaltung der Erfindung sieht vor, dass einem Hauptpfad der PLL-Schaltung ein zur Steuersignalerzeugung beitragender Abgleichpfad parallel geschaltet ist. In diesem Fall kennzeichnet sich eine vorteilhafte Verfahrensvariante dadurch, dass der Abgleichpfad zumindest während des deaktivierten Zustands des digitalen Modulationssignals aktiviert ist.

Ferner kann vorgesehen sein, dass der Hauptpfad der PLL-Schaltung während des deaktivierten Zustands des digitalen Modulationssignals deaktiviert wird, indem beispielsweise ein Strom, welcher von einer im Hauptpfad befindlichen Ladungspumpe erzeugt wird, auf den Wert Null gesetzt wird. Dadurch wird erreicht, dass eine dem digitalen Modulationssignal entsprechende Spannung an einem Tuning-Eingang eines spannungsgesteuerten Oszillators während der nachfolgenden Schritte im Wesentlichen konstant bleibt. Jedoch ist es alternativ zu der beschriebenen Maßnahme wesentlich vorteilhafter, wenn der Hauptpfad der PLL-Schaltung eine kleinere Frequenzbandbreite als der Abgleichpfad aufweist. Sofern des Weiteren die zweite Frequenz innerhalb der Frequenzbandbreite des Abgleichpfads, aber außerhalb der Frequenzbandbreite des Hauptpfads liegt, kann der Hauptpfad nach der Deaktivierung des digitalen Modulationssignals dieser Modulationsänderung nicht folgen, sodass sich dadurch an dem Tuning-Eingang des spannungsgesteuerten Oszillators eine im Wesentlichen konstante Spannung einstellt.

Diese vorstehend aufgeführte Maßnahme kann beispielsweise dadurch realisiert werden, dass der Hauptpfad und der Abgleichpfad jeweils ein Schleifenfilter enthalten, wobei die Schleifenfilterbandbreite des im Hauptpfad angeordneten Schleifenfilters kleiner als diejenige des im Abgleichpfad angeordneten Schleifenfilters ist.

Die Aufrechterhaltung der beim anfänglichen Einprägen des digitalen Modulationssignals an dem Tuning-Eingang des spannungsgesteuerten Oszillators erzeugten Spannung kann im allgemeinen jedoch auch auf andere Weise realisiert werden. Eine weitere Möglichkeit dazu besteht darin, den Hauptpfad der PLL-Schaltung nach dem Einprägen des digitalen Modulationssignals aktiv zu halten und einen Strom durch die Ladungspumpe im Hauptpfad der PLL-Schaltung derart einzustellen, dass die Spannung am Tuning-Eingang des spannungsgesteuerten Oszillators im Wesentlichen konstant gehalten wird. Dadurch kann erreicht werden, dass eine Änderung der Spannung am Tuning-Eingang des spannungsgesteuerten Oszillators aufgrund von Leckströmen im Hauptpfad während des Abgleichens verhindert wird.

Ferner ist es vorteilhaft, wenn im Schritt (a) des erfindungsgemäßen Verfahrens der Abgleichpfad deaktiviert ist und ein von dem Abgleichpfad gespeister Modulationseingang eines spannungsgesteuerten Oszillators auf eine Referenzspannung, von beispielsweise 0 Volt, vorgeladen wird.

Des Weiteren wird vorzugsweise das digitale Modulationssignal über einen Frequenzteiler, welcher im Rückkopplungszweig der PLL-Schaltung angeordnet ist, in die PLL-Schaltung eingeprägt. Als Eingang für das digitale Modulationssignal dient ein Steueranschluss des Frequenzteilers. Diesem Steuereingang kann vorteilhafterweise ein Sigma-Delta-Modulator vorgeschaltet sein. In diesem Fall ist es besonders vorteilhaft, die Kanalmittenfrequenz derart zu wählen, dass der Quotient aus der Kanalmittenfrequenz und der Frequenz eines Referenzsignals, welches zur Ansteuerung des spannungsgesteuerten Oszillators genutzt wird, im Wesentlichen ganzzahlig ist. Dies hat den Vorteil, dass im PLL-Regelkreis kein durch den Sigma-Delta-Modulator verursachtes Quantisierungsrauschen auftritt, welches bei einer großen Schleifenfilterbandbreite des im Abgleichpfad angeordneten Schleifenfilters zu einem fehlerbehafteten Abgleichvorgang führen könnte.

Ein weiterer Aspekt der Erfindung betrifft eine PLL-Schaltung, die für das Einprägen eines analogen und eines digitalen Modulationssignals nach dem Prinzip der Zwei-Punkt-Modulation ausgebildet ist. Einem Hauptpfad der PLL-Schaltung ist ein Abgleichpfad parallel geschaltet, welcher ein Auskoppelmittel zur Erzeugung eines Differenzsignals umfasst. Das Differenzsignal ist für die Änderung eines Steuersignals einer frequenzerzeugenden Einheit beim Einprägen unterschiedlicher digitaler Modulationssignale in die PLL-Schaltung charakteristisch. Weiterhin umfasst der Abgleichpfad eine Vergleichseinheit zum Vergleichen des Differenzsignals mit einem Vergleichssignal, welches charakteristisch für einen Modulationshub eines analogen Modulationssignals ist, und eine Modulationseinheit, die den Modulationshub des analogen Modulationssignals in Abhängigkeit von einem Ausgangssignal der Vergleichseinheit verändert.

Durch die erfindungsgemäße PLL-Schaltung mit dem Hauptpfad und dem dazu parallel geschalteten Abgleichpfad ist ein relativ einfacher und aufwandsarmer Schaltungsaufbau gegeben, mit welchem ein schneller und genauer Abgleich des digitalen und des analogen Modulationssignals durchgeführt werden kann.

Vorzugsweise ist in dem Hauptpfad der PLL-Schaltung eine erste Ladungspumpe und ein der ersten Ladungspumpe nachgeschaltetes erstes Schleifenfilter angeordnet. Analog dazu befindet sich vorzugsweise in dem Abgleichpfad eine zweite Ladungspumpe und ein der zweiten Ladungspumpe nachgeschaltetes zweites Schleifenfilter.

Eine besonders vorteilhafte Ausgestaltung der Erfindung sieht vor, dass der Hauptpfad der PLL-Schaltung eine geringere Frequenzbandbreite als der Abgleichpfad aufweist. Diese Maßnahme ist wie oben bereits erläutert wurde vorteilhaft, um den PLL-Regelkreis bei einer entsprechenden Änderung des digitalen Modulationssignals über den Abgleichpfad zu schließen. Dies kann insbesondere dadurch erzielt werden, dass die Schleifenfilterbandbreite des ersten Schleifenfilters kleiner als diejenige des zweiten Schleifenfilters ist.

Bei einer weiteren vorteilhaften Ausgestaltung der Erfindung ist vorgesehen, dass über einen ersten Schalter das Differenzsignal an einen Modulationseingang eines spannungsgesteuerten Oszillators der PLL-Schaltung anlegbar ist. Weiterhin kann vorteilhafterweise vorgesehen sein, dass der Abgleichpfad einen zweiten Schalter aufweist, in dessen geschlossener Stellung das Vergleichssignal an einem Eingang der Vergleichseinheit anliegt.

Die Erfindung wird nachfolgend anhand von Ausführungsbeispielen und unter Bezugnahme auf die Zeichnungen näher erläutert.
Es zeigen:
- Fig. 1: ein schematisches Schaltbild eines Ausführungsbeispiels der erfindungsgemäßen nach dem Prinzip der Zwei-Punkt-Modulation arbeitenden PLL-Schaltung; und
- Fig. 2: ein schematisches Ablaufdiagramm eines Ausführungsbeispiels des erfindungsgemäßen Abgleichverfahrens.

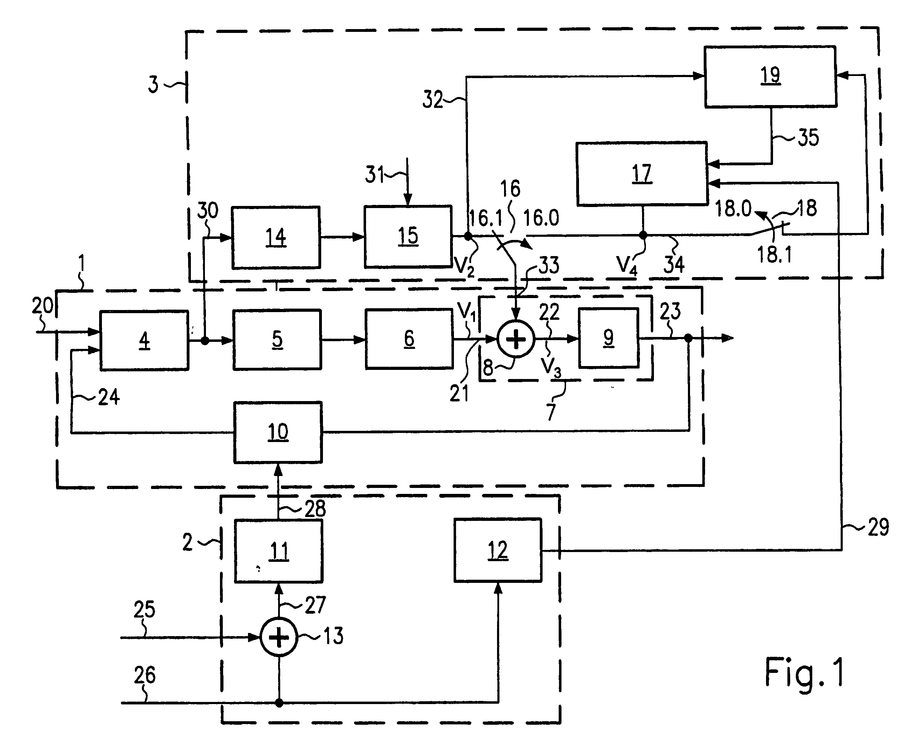

In Fig. 1 ist schematisch ein Schaltbild ein Ausführungsbeispiel des erfindungsgemäßen Zwei-Punkt-Modulators dargestellt. Der vorliegende Zwei-Punkt-Modulator umfasst eine PLL-Schaltung 1, eine Modulationsvorrichtung 2 und eine Abgleichvorrichtung 3.

Die PLL-Schaltung 1 weist in ihrem Hauptpfad einen Phasenfrequenzdetektor (englisch: phase frequency detector) 4, eine Ladungspumpe (englisch: charge pump) 5, ein Schleifenfilter (englisch: loop filter) 6 und einen spannungsgesteuerten Oszillator (englisch: voltage controlled oscillator; VCO) 7 auf. Das Schleifenfilter 6 ist als Tiefpassfilter ausgeführt, wodurch höherfrequente Signalanteile geglättet werden. Der spannungsgesteuerte Oszillator 7 stellt das schwingungserzeugende Bauelement in der PLL-Schaltung 1 dar und weist einen Summationspunkt 8 und eine frequenzerzeugende Einheit 9 auf. Über einen Rückkopplungszweig, welcher sich vom Ausgang des spannungsgesteuerten Oszillators 7 zu einem Eingang des Phasenfrequenzdetektors 4 erstreckt und in dem ein programmierbarer Frequenzteiler (englisch: frequency divider) 10 angeordnet ist, wird die PLL-Schaltung 1 geschlossen. Der programmierbare Frequenzteiler 10 kann beispielsweise als Fraktional-N-Frequenzteiler ausgeführt sein, wodurch auch eine Frequenzteilung durch eine nicht ganze Zahl ermöglicht wird.

Zur Aufbereitung eines digitalen Modulationssignals 26 weist die Modulationsvorrichtung 2 eine Programmiereinheit 11 und einen Digital-Analog-Wandler (englisch: digital to analog converter) 12 auf.

Parallel zum Hauptpfad der PLL-Schaltung 1 ist ein Abgleichpfad der Abgleichvorrichtung 3 geschaltet. Der Abgleichpfad weist eine Ladungspumpe 14 und ein der Ladungspumpe 14 nachgeschaltetes Schleifenfilter 15 auf. Ferner umfasst die Abgleichvorrichtung 3 eine analoge Modulationseinheit 17 und eine Komparatoreinheit 19. Ein Eingang der Komparatoreinheit 19 ist an den Ausgang des Schleifenfilters 15 gekoppelt. In Abhängigkeit von dem Betriebsmodus werden das Schleifenfilter 15 oder die analoge Modulationseinheit 17 über einen Schalter 16 mit einem Modulationseingang 33 des spannungsgesteuerten Oszillators 7 der PLL-Schaltung 1 elektrisch verbunden. Über einen Schalter 18 ist der Ausgang der analogen Modulationseinheit 17 mit einem weiteren Eingang der Komparatoreinheit 19 rückkoppelbar. Der Ausgang der Komparatoreinheit 19 ist mit einem Steuereingang der analogen Modulationseinheit 17 verbunden.

Bei der Zwei-Punkt-Modulation werden der PLL-Schaltung 1 über die Modulationsvorrichtung 2 ein analoges und ein digitales Modulationssignal eingeprägt. Da das analoge Modulationssignal im Gegensatz zum digitalen Modulationssignal, welches aufgrund seiner diskreten Natur keine Toleranzen aufweist, drift- und toleranzbehaftet ist, ist es erforderlich, die beiden Modulationssignale hinsichtlich ihrer Amplituden abzugleichen.

Das Modulationssignal 26, welches in dem vorliegenden Ausführungsbeispiel als digitales Signal ausgeführt ist, wird an einem Summationspunkt 13 auf ein der PLL-Frequenzsynthese zugrunde liegendes Trägersignal 25 addiert. Das resultierende Signal 27 liegt an einem Eingang der Programmiereinheit 11 an.

Die Programmiereinheit 11, die im Ausführungsbeispiel als Sigma-Delta-Modulator ausgeführt ist, erzeugt an ihrem Ausgang ein digitales Modulationssignal 28, welches an einem Steueranschluss des programmierbaren Frequenzteilers 10 anliegt. Das digitale Modulationssignal 28 gibt dabei den Summanden ΔN eines Teilerverhältnisses von 1/(N + ΔN) an, wobei der Summand N beispielsweise fest eingestellt ist und der Term (N + ΔN) eine ganze Zahl darstellt. Dadurch wird das Modulationssignal 26 mit einem durch die Modulation bestimmten (variablen) Frequenzteilungsverhältnis über den programmierbaren Frequenzteiler 10 in den Rückkopplungszweig der PLL-Schaltung 1 eingeprägt. Am Ausgang des programmierbaren Frequenzteilers 10 wird ein Frequenzteilersignal 24 erzeugt, welches an einem Eingang des Phasenfrequenzdetektors 4 anliegt.

An einem weiteren Eingang des Phasenfrequenzdetektors 4 liegt ein Referenzsignal 20 mit einer Referenzfrequenz f_{ref} an. Die Referenzfrequenz f_{ref} kann beispielsweise durch einen nicht in der Fig. 1 dargestellten Schwingquarz erzeugt werden. Dadurch wird am Ausgang des Phasenfrequenzdetektors 4 ein Differenzsignal 30 erzeugt, das die Frequenz- und/oder Phasendifferenz zwischen dem Referenzsignal 20 und dem Frequenzteilersignal 24 wiedergibt. Das Differenzsignal 30 des Phasenfrequenzdetektors 4 wird zur Ansteuerung der Ladungspumpe 5 verwendet. In der Ladungspumpe 5 wird ein Strom erzeugt, dessen Größe von dem Differenzsignal 30 abhängig ist. Mit dem in der Ladungspumpe 5 erzeugten Strom wird das Schleifenfilter 6 aufgeladen. Das Ausgangssignal des Schleifenfilters 6 ist ein Spannungssignal und liegt an einem Tuning-Eingang 21 des spannungsgesteuerten Oszillators 7 an. Ein am Ausgang des spannungsgesteuerten Oszillators 7 erzeugtes Ausgangssignal 23 ist sowohl das Rückkopplungssignal der PLL-Schaltung 1, welches den Eingang des programmierbaren Frequenzteilers 10 speist, als auch das Ausgangssignal des vorliegenden Zwei-Punkt-Modulators sowie der PLL-Schaltung 1.

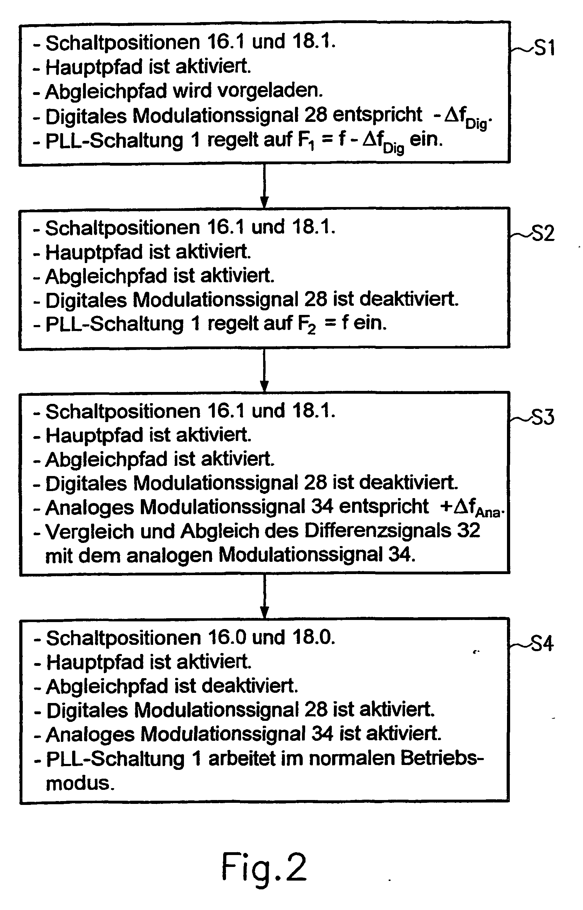

Ein Ausführungsbeispiel des erfindungsgemäßen Abgleichverfahrens wird nachfolgend beispielhaft anhand des in Fig. 1 gezeigten Zwei-Punkt-Modulators erläutert. In Fig. 2 ist dieses Ausführungsbeispiel schematisch in einem Ablaufdiagramm dargestellt.

In einem ersten Schritt S1 verbindet der Schalter 16 den Ausgang des Schleifenfilters 15 mit dem Modulationseingang 33 des spannungsgesteuerten Oszillators 7. Diese Schaltposition des Schalters 16 wird nachfolgend sowie in Fig. 1 mit 16.1 bezeichnet. Die andere Schaltposition des Schalters 16 wird mit 16.0 bezeichnet. Der Schalter 18 ist während des Schritts S1 geschlossen. Die geschlossene Schaltposition des Schalters 18 wird mit 18.1 bezeichnet, während seine geöffnete Schaltposition mit 18.0 bezeichnet wird. Das digitale Modulationssignal 28 wird mit einem konstanten Teilerverhältnis in den programmierbaren Frequenzteiler 10 eingegeben. Das Teilerverhältnis ist derart, dass die PLL-Schaltung 1 auf eine Frequenz F₁ einregelt, die einer Kanalmittenfrequenz f abzüglich eines digitalen Modulationshubs Δf_{Dig} entspricht.

Indem die PLL-Schaltung 1 auf die Frequenz F₁ = f - Δf_{Dig} eingeregelt wird, stellt sich am Tuning-Eingang 21 des spannungsgesteuerten Oszillators 7 ein Spannungswert V₁ ein, welcher der Frequenz F₁ entspricht. Zum Beispiel ist der Spannungswert V₁ im Falle einer linearen Frequenz-Spannungs-Kennlinie des spannungsgesteuerten Oszillators 7 zu der Frequenz F₁ proportional.

Während des Einregelvorgangs der PLL-Schaltung 1 auf die Frequenz F₁ ist der Abgleichpfad der Abgleichvorrichtung 3 deaktiviert. Währenddessen wird das Schleifenfilter 15 mittels eines Ladesignals 31 auf den festen Spannungswert Null vorgeladen. Dadurch wird der Modulationseingang 33 des spannungsgesteuerten Oszillators 7 ebenfalls auf einen festen Spannungswert vorgeladen.

Nachdem der Einregelvorgang der PLL-Schaltung 1 auf die Frequenz F₁ abgeschlossen ist, wird in einem zweiten Schritt S2 das digitale Modulationssignal 28 auf den Wert Null gesetzt. Die Schalter 16 und 18 bleiben dabei unverändert in den Schaltpositionen 16.1 und 18.1. Der Abgleichpfad wird nun aktiviert. Dadurch wird die PLL-Schaltung 1 auf eine Frequenz F₂ eingeregelt. Die Bandbreite des Schleifenfilters 15 ist vorliegend deutlich größer ausgelegt als diejenige des Schleifenfilters 6. Aufgrund der geringen Bandbreite des mit der Ladungspumpe 5 und dem Schleifenfilter 6 gebildeten Hauptpfads der PLL-Schaltung 1 kann der Hauptpfad der Änderung des digitalen Modulationssignals 28 nicht folgen, sodass die Spannung an dem Tuning-Eingang 21 des spannungsgesteuerten Oszillators 7 im Wesentlichen konstant bleibt.

Somit ist die Regelschleife der PLL-Schaltung 1 für die Dauer des Abgleichvorgangs über den Abgleichpfad, d.h. über die Ladungspumpe 14, das Schleifenfilter 15 und den Modulationseingang 33 des spannungsgesteuerten Oszillators 7, geschlossen.

Die durch das Deaktivieren des digitalen Modulationssignals 28 erzeugte Frequenz F₂ der PLL-Schaltung ist gleich der Kanalmittenfrequenz f. Am Tuning-Eingang 21 des spannungsgesteuerten Oszillators 7 liegt weiterhin der Spannungswert V₁ an. Am Modulationsseingang 33 des spannungsgesteuerten Oszillators 7 stellt sich ein Spannungswert V₂ ein, der dem digitalen Modulationshub Δf_{Dig} entspricht.

Dieser Spannungswert V₂ resultiert daraus, dass die Ausgangsfrequenz des spannungsgesteuerten Oszillators 7 der zweiten Frequenz F₂ entspricht, auf welche die PLL-Schaltung 1 eingeregelt wird. An der frequenzerzeugenden Einheit 9 liegt daher ein Steuersignal 22 an, dessen Spannung V₃ die Frequenz F₂ erzeugt. Aufgrund der Summationsbedingung am Summationspunkt 8 sowie der konstanten Spannung V₁ am Tuning-Eingang 21 des spannungsgesteuerten Oszillators 7, ergibt sich daher am Modulationseingang 33 des spannungsgesteuerten Oszillators 7 ein Differenzsignal 32 mit einem Spannungswert V₂(Δf_{Dig}) = V₃(f) - V₁(f - Δf_{Dig}).

Da in dem vorliegenden Ausführungsbeispiel die Programmiereinheit 11 als Sigma-Delta-Modulator ausgelegt ist, wird die Kanalmittenfrequenz f so gewählt, dass der Quotient f/f_{ref} ganzzahlig ist. Diese Einstellung ist insofern vorteilhaft, als dass dadurch ein durch den Sigma-Delta-Modulator verursachtes Quantisierungsrauschen unterdrückt wird, welches aufgrund der hohen Bandbreite des Schleifenfilters 15 zu einem Fehler in dem weiteren Abgleichvorgang führen könnte.

In einem dritten Schritt S3 soll das am Ausgang des Schleifenfilters 15 abgreifbare Differenzsignals 32 mit einem analogen Modulationssignal 34 verglichen werden. Die Schalter 16 und 18 bleiben dabei weiterhin unverändert in den Schaltpositionen 16.1 und 18.1. Das digitale Modulationssignal 26 wird durch den Digital-Analog-Wandler 12 in ein analoges Modulationssignal 29 gewandelt und an einen Eingang der analogen Modulationseinheit 17 angelegt. Die analoge Modulationseinheit 17 erzeugt ein analoges Modulationssignal 34. Das analoge Modulationssignal 34 soll bei entsprechenden Schaltstellungen der Schalter 16 und 18 am Ausgang des spannungsgesteuerten Oszillators 7 eine aus der Summe von der Kanalmittenfrequenz f und einem analogen Modulationshub Δf_{Ana} gebildete Frequenz F₃ = f + Δf_{Ana} bewirken. Der dieser Frequenz F₃ entsprechende Spannungswert V₄ am Modulationseingang 33 muss im abgeglichenen Zustand genauso so groß wie der Spannungswert V₂ sein. Zur Bewerkstelligung des Vergleichs mit dem Spannungswert V₂ wird das analoge Modulationssignal 34 an einen Eingang der Komparatoreinheit 19 angelegt. Der Spannungswert V₂ des Differenzsignals 32 liegt an einem weiteren Eingang der Komparatoreinheit 19 an.

Eine in der Komparatoreinheit 19 ermittelte Abweichung zwischen dem Spannungswert V₂ des Differenzsignals 32 und dem Spannungswert V₄ des analogen Modulationssignals 34 wird beseitigt, indem der analoge Modulationshub Δf_{Ana} des am Ausgang der analogen Modulationseinheit 17 bereitgestellten analogen Modulationssignals 34 verändert wird. Zu diesem Zweck wird die in der Komparatoreinheit 19 ermittelte Abweichung durch ein Ausgangssignal 35 der analogen Modulationseinheit 17 zugeführt.

Alternativ kann die dem Differenzsignal 32 entsprechende Spannung V₂ am Eingang der Komparatoreinheit 19, beispielsweise durch einen Kondensator, gespeichert werden und anschließend mit dem Spannungswert V₄ des analogen Modulationssignals 34 verglichen werden. Sobald die Differenz zwischen den Spannungswerten V₂ und V₄ beseitigt ist, ist eine Anpassung zwischen dem digitalen Modulationshub Δf_{Dig} und dem analogen Modulationshub Δf_{Ana} erreicht.

In einem vierten Schritt S4 werden nach Abschluss des Abgleichvorgangs die Schalter 16 und 18 in die Schaltpositionen 16.0 und 18.0 umgeschaltet, und die Ladungspumpe 14 sowie das Schleifenfilter 15 werden deaktiviert. Die PLL-Schaltung 1 wird dadurch über den Hauptpfad geschlossen.

Die PLL-Schaltung 1 ist für die Zwei-Punkt-Modulation nun abgeglichen und kann ihren Betrieb aufnehmen. Das digitale Modulationssignal 28 und das analoge Modulationssignal 34 überlagern sich dabei und es ergibt sich infolge des beschriebenen Abgleichvorgangs ein frequenzunabhängiges Übertragungsverhalten der PLL-Schaltung 1.

Wird anstelle des digitalen Modulationssignals 26 ein analoges Modulationssignal verwendet, kann die Modulationsvorrichtung 2 beispielsweise auch derart ausgeführt sein, dass der Digital-Analog-Wandler 12 nicht benötigt wird, aber stattdessen eine entsprechende Signalwandlung im digitalen Modulationspfad durchgeführt wird.

Das Abgleichen der an die Komparatoreinheit 19 angelegten Signale kann beispielsweise in einem iterativen Prozess erfolgen. In diesem Fall erfolgt ein approximativer Abgleich der Modulationsamplituden mit wechselweiser Aktualisierung des analogen Modulationssignals 34 und Bewertung des daraufhin erhaltenen, geänderten Ausgangssignals 35 der Komparatoreinheit 19. Bei erfolgter Beseitigung der Spannungsdifferenz an der Komparatoreinheit 19 ist der Abgleich zwischen dem digitalen Modulationshub Δf_{Dig} und dem analogen Modulationshub Δf_{Ana} erreicht.

## Patentansprüche

1. Abgleichverfahren für eine nach dem Prinzip der Zwei-Punkt-Modulation arbeitende PLL-Schaltung (1), mit den folgenden in der angegebenen Reihenfolge ausgeführten Schritten:
(a) Einprägen eines digitalen Modulationssignals (28) in die PLL-Schaltung (1), wobei die PLL-Schaltung (1) auf eine erste Frequenz einregelt;
(b) Deaktivieren des digitalen Modulationssignals (28), wobei die PLL-Schaltung (1) auf eine zweite Frequenz einregelt, welche unterschiedlich zu der ersten Frequenz ist;
(c) Auskoppeln eines Differenzsignals (32), welches der durch das Deaktivieren des digitalen Modulationssignals (28) bewirkten Änderung eines Steuersignals (22) einer frequenzerzeugenden Einheit (9) der PLL-Schaltung (1) entspricht;
(d) Vergleichen des Differenzsignals (32) mit einem Vergleichssignal (34), welches charakteristisch für einen Modulationshub eines analogen Modulationssignals (34) ist; und
(e) Ändern des Modulationshubs derart, dass eine bei dem Vergleich ermittelte Abweichung zwischen dem Differenzsignal (34) und dem Vergleichssignal (34) beseitigt wird.

2. Verfahren nach Anspruch 1,
**ddadurch gekennzeichnet,**
- **dass** durch das Einprägen des digitalen Modulationssignals (28) die PLL-Schaltung (1) auf eine erste Frequenz eingeregelt wird, die durch das Subtrahieren einer Frequenz eines variabel wählbaren, digitalen Modulationshubs von einer Kanalmittenfrequenz gebildet wird.

3. Verfahren nach einem der Ansprüche 1 oder 2,
**dadurch gekennzeichnet,**
- **dass** durch das Deaktivieren des digitalen Modulationssignals (28) die PLL-Schaltung (1) auf eine zweite Frequenz eingeregelt wird, die gleich der Kanalmittenfrequenz ist.

4. Verfahren nach einem oder mehreren der vorhergehenden Ansprüche,
**dadurch gekennzeichnet,**
- **dass** einem Hauptpfad der PLL-Schaltung (1) ein zur Steuersignalerzeugung beitragender Abgleichpfad parallel geschaltet ist, mit dem Schritt:
- Aktivieren des Abgleichpfads zumindest während des deaktivierten Zustands des digitalen Modulationssignals (28).

5. Verfahren nach Anspruch 4,
**dadurch gekennzeichnet,**
- **dass** der Hauptpfad der PLL-Schaltung (1) eine kleinere Frequenzbandbreite als der Abgleichpfad aufweist, und
- **dass** insbesondere die zweite Frequenz außerhalb der Frequenzbandbreite des Hauptpfads und innerhalb der Frequenzbandbreite des Abgleichpfads liegt.

6. Verfahren nach Anspruch 5,
**dadurch gekennzeichnet,**
- **dass** der Hauptpfad ein erstes Schleifenfilter (6) mit einer ersten Schleifenfilterbandbreite aufweist, und
- **dass** der Abgleichpfad ein zweites Schleifenfilter (15) mit einer zweiten Schleifenfilterbandbreite aufweist, wobei die erste Schleifenfilterbandbreite kleiner als die zweite Schleifenfilterbandbreite ist.

7. Verfahren nach einem oder mehreren der Ansprüche 4 bis 6,
**dadurch gekennzeichnet,**
- **dass** im Schritt (a) der Abgleichpfad deaktiviert ist und ein von dem Abgleichpfad gespeister Modulationseingang (33) eines spannungsgesteuerten Oszillators (7) auf eine Referenzspannung vorgeladen wird.

8. Verfahren nach einem oder mehreren der vorhergehenden Ansprüche,
**dadurch gekennzeichnet,**
- **dass** das digitale Modulationssignal (28) über einen im Rückkopplungszweig der PLL-Schaltung (1) angeordneten Frequenzteiler (10) eingeprägt wird.

9. Verfahren nach Anspruch 8,
**dadurch gekennzeichnet,**
- **dass** ein Steuereingang des Frequenzteilers (10) durch einen Sigma-Delta-Modulator (11) gespeist wird, und
- **dass** die Kanalmittenfrequenz derart gewählt wird, dass der Quotient aus der Kanalmittenfrequenz und der Frequenz eines zur Ansteuerung des spannungsgesteuerten Oszillators (7) genutzten Referenzsignals (20) im Wesentlichen ganzzahlig ist.

10. PLL-Schaltung (1), die für das Einprägen eines analogen Modulationssignals (34) und eines digitalen Modulationssignals (28) nach dem Prinzip der Zwei-Punkt-Modulation ausgelegt ist, wobei einem Hauptpfad der PLL-Schaltung (1) ein Abgleichpfad parallel geschaltet ist,
**dadurch gekennzeichnet,**
- **dass** der Abgleichpfad
- ein Auskoppelmittel (14, 15) zur Erzeugung eines Differenzsignals (32) umfasst, welches für die Änderung eines Steuersignals (22) einer frequenzerzeugenden Einheit (9) der PLL-Schaltung (1) beim Einprägen unterschiedlicher digitaler Modulationssignale (28) in die PLL-Schaltung (1) charakteristisch ist,
- eine Vergleichseinheit (19) zum Vergleichen des Differenzsignals (32) mit einem Vergleichssignal (34) umfasst, welches charakteristisch für einen Modulationshub eines analogen Modulationssignals (34) ist, und
- eine Modulationseinheit (17) umfasst, die den Modulationshub des analogen Modulationssignals (34) in Abhängigkeit von einem Ausgangssignal (35) der Vergleichseinheit (19) verändert.

11. PLL-Schaltung (1) nach Anspruch 10,
**dadurch gekennzeichnet,**
- **dass** der Hauptpfad der PLL-Schaltung (1) eine erste Ladungspumpe (5) und ein der ersten Ladungspumpe (5) nachgeschaltetes erstes Schleifenfilter (6) umfasst.

12. PLL-Schaltung (1) nach Anspruch 10 oder 11,
**dadurch gekennzeichnet,**
- **dass** das Auskoppelmittel (14, 15) eine zweite Ladungspumpe (14) und ein der zweiten Ladungspumpe (14) nachgeschaltetes zweites Schleifenfilter (15) umfasst.

13. PLL-Schaltung (1) nach einem oder mehreren der Ansprüche 10 bis 12,
**dadurch gekennzeichnet,**
- **dass** der Hauptpfad der PLL-Schaltung (1) eine kleinere Frequenzbandbreite als der Abgleichpfad aufweist, und
- **dass** insbesondere die Schleifenfilterbandbreite des ersten Schleifenfilters (6) kleiner als die Schleifenfilterbandbreite des zweiten Schleifenfilters (15) ist.

14. PLL-Schaltung (1) nach einem oder mehreren der Ansprüche 10 bis 13,
**gekennzeichnet durch**
- einen ersten Schalter (16), über welchen das Differenzsignal (32) an einen Modulationseingang (33) eines spannungsgesteuerten Oszillators (7) der PLL-Schaltung (1) anlegbar ist.

15. PLL-Schaltung (1) nach einem oder mehreren der Ansprüche 10 bis 14,
**gekennzeichnet durch**
- einen zweiten Schalter (18), in dessen geschlossener Stellung das Vergleichssignal (34) an einem Eingang der Vergleichseinheit (19) anliegt.

## Claims

1. Trimming method for a PLL circuit (1) which operates on the principle of two-point modulation, having the following steps, which are carried out in the stated sequence:
(a) injection of a digital modulation signal (28) into the PLL circuit (1), with the PLL circuit (1) regulating at a first frequency;
(b) deactivation of the digital modulation signal (28), with the PLL circuit (1) regulating at a second frequency, which is not the same as the first frequency;
(c) outputting of a difference signal (32), which corresponds to the change in a control signal (22), which is produced by the deactivation of the digital modulation signal (28), for a frequency-generating unit (9) in the PLL circuit (1);
(d) comparison of the difference signal (32) with a comparison signal (34), which is characteristic of a modulation shift of an analogue modulation signal (34); and
(e) changing of the modulation shift such that any discrepancy between the difference signal (34) and the comparison signal (34) which is determined during the comparison is corrected.

2. Method according to Claim 1,
**characterized**
- **in that** the injection of the digital modulation signal (28) results in the PLL circuit (1) being regulated at a first frequency, which is formed by the subtraction of a frequency of a variably selectable, digital modulation shift from a channel mid-frequency.

3. Method according to one of Claims 1 or 2,
**characterized**
- **in that** the deactivation of the digital modulation signal (28) results in the PLL circuit (1) being regulated at a second frequency, which is the same as the channel mid-frequency.

4. Method according to one or more of the preceding claims,
**characterized**
- **in that** a main path in the PLL circuit (1) is connected in parallel with a trimming path which contributes to control signal generation, having the following step:
- activation of the trimming path at least during the deactivated state of the digital modulation signal (28).

5. Method according to Claim 4,
**characterized**
- **in that** the main path in the PLL circuit (1) has a narrower frequency bandwidth than the trimming path, and
- **in that**, in particular, the second frequency is outside the frequency bandwidth of the main path, and is within the frequency bandwidth of the trimming path.

6. Method according to Claim 5,
**characterized**
- **in that** the main path has a first loop filter (6) with a first loop filter bandwidth, and
- **in that** the trimming path has a second loop filter (15) with a second loop filter bandwidth, with the first loop filter bandwidth being narrower than the second loop filter bandwidth.

7. Method according to one or more of Claims 4 to 6,
**characterized**
- **in that** the trimming path is deactivated in step (a), and a modulation input (33) (which is fed from the trimming path) of a voltage-controlled oscillator (7) is precharged to a reference voltage.

8. Method according to one or more of the preceding claims,
**characterized**
- **in that** the digital modulation signal (28) is injected via a frequency divider (10) which is arranged in the feedback path of the PLL circuit (1).

9. Method according to Claim 8,
**characterized**
- **in that** a control input of the frequency divider (10) is fed by a sigma-delta modulator (11), and
- **in that** the channel mid-frequency is selected such that the quotient of the channel mid-frequency divided by the frequency of a reference signal (20) which is used for driving the voltage controlled oscillator (7) is essentially an integer.

10. PLL circuit (1) which is designed for injection of an analogue modulation signal (34) and of a digital modulation signal (28) on the basis of the two-point modulation principle, with a main path in the PLL circuit (1) being connected in parallel with a trimming path,
**characterized in that** the trimming path
- has an output means (14, 15) for production of a difference signal (32) which is characteristic of the change in a control signal (22) for a frequency-generating unit (9) in the PLL circuit (1) when different digital modulation signals (28) are injected into the PLL circuit (1)
- has a comparison unit (19) for comparison of the difference signal (32) with a comparison signal (34) which is characteristic of a modulation shift of an analogue modulation signal (34), and
- has a modulation unit (17), which changes the modulation shift of the analogue modulation signal (34) as a function of an output signal (35) from the comparison unit (19).

11. PLL circuit (1) according to Claim 10,
**characterized**
- **in that** the main path in the PLL circuit (1) has a first charge pump (5) and a first loop filter (6), which is connected downstream from the first charge pump (5).

12. PLL circuit (1) according to Claim 10 or 11,
**characterized**
- **in that** the output means (14, 15) has a second charge pump (14) and a second loop filter (15), which is connected downstream from the second charge pump (14).

13. PLL circuit (1) according to one or more of Claims 10 to 12,
**characterized**
- **in that** the main path in the PLL circuit (1) has a narrower frequency bandwidth than the trimming path, and
- **in that**, in particular, the loop filter bandwidth of the first loop filter (6) is narrower than the loop filter bandwidth of the second loop filter (15).

14. PLL circuit (1) according to one or more of Claims 10 to 13,
**characterized by**
- a first switch (16), via which the difference signal (32) can be applied to a modulation input (33) of a voltage controlled oscillator (7) in the PLL circuit (1).

15. PLL circuit (1) according to one or more of Claims 10 to 14,
**characterized by**
- a second switch (18), in whose closed position the comparison signal (34) is applied to an input of the comparison unit (19).

## Revendications

1. Procédé d'équilibrage pour un circuit (1) PLL fonctionnant suivant le principe de la modulation à deux points, comprenant les stades suivants exécutés dans l'ordre indiqué :
injection d'un signal (28) numérique de modulation dans le circuit (1) PLL, le circuit (1) PLL étant réglé à une première fréquence ;
désactivation du signal (28) numérique de modulation, le circuit (1) PLL étant réglé à une deuxième fréquence qui est différente de la première fréquence ;
sortie d'un signal (32) de différence qui correspond à la variation, provoquée par la désactivation du signal numérique de modulation, d'un signal (22) de commande d'une unité (2) produisant la fréquence du circuit (1) PLL ;
comparaison du signal (32) de différence avec un signal (34) de comparaison qui est caractéristique d'une excursion de modulation d'un signal (34) analogique de modulation ; et
modification de l'excursion de modulation de façon à ce qu'un écart, déterminé lors de la comparaison, entre le signal (34) de différence et le signal (34) de comparaison soit éliminé.

2. Procédé suivant la revendication 1,
**caractérisé**
- **en ce que**, par l'injection du signal (28) numérique de modulation, on règle le circuit PLL à une première fréquence qui est formée en soustrayant une fréquence d'une excursion numérique de modulation qui peut être choisie variable d'une fréquence médiane de canal.

3. Procédé suivant l'une des revendications 1 ou 2,
**caractérisé**
- **en ce que** l'on règle en désactivant le signal (28) numérique de modulation le circuit (1) PLL à une deuxième fréquence qui est égale à la fréquence médiane du canal.

4. Procédé suivant l'une ou plusieurs des revendications précédentes,
**caractérisé**
- **en ce que** l'on monte en parallèle à une voie principale du circuit (1) PLL une voie d'équilibrage contribuant à la production du signal de commande comprenant le stade :
- d'activation de la voie d'équilibrage au moins pendant l'état désactivé du signal (28) numérique de modulation.

5. Procédé suivant la revendication 4,
**caractérisé**
- **en ce que** la voie principale du circuit (1) PLL a une largeur de bande de fréquence plus petite que la voie d'équilibrage, et
- **en ce que** notamment la deuxième fréquence est à l'extérieur de la largeur de bande de fréquence de la voie principale et à l'intérieur de la largeur de bande de fréquence de la voie d'équilibrage.

6. Procédé suivant la revendication 5,
**caractérisé**
- **en ce que** la voie principale a un premier filtre (6) à boucle ayant une première largeur de bande de filtre à boucle, et
- **en ce que** la voie d'équilibrage a un deuxième filtre (15) à boucle ayant une deuxième largeur de bande de filtre à boucle, dans lequel la première largeur de bande de filtre à boucle est plus petite que la deuxième largeur de bande de filtre à boucle.

7. Procédé suivant l'une ou plusieurs des revendications 4 à 6,
**caractérisé**
- **en ce qu'**au stade (a), on désactive la voie d'équilibrage et on précharge une entrée (33) de modulation alimentée par la voie d'équilibrage d'un oscillateur (7) commandé par la tension jusqu'à une tension de référence.

8. Procédé suivant l'une ou plusieurs des revendications précédentes,
**caractérisé**
- **en ce que** l'on injecte le signal (28) numérique de modulation par un diviseur (10) de fréquence monté dans la voie de réaction du circuit (1) PLL.

9. Procédé suivant la revendication 8,
**caractérisé**
- **en ce que** l'on alimente une entrée de commande du diviseur (10) de fréquence par un modulateur (11) sigma delta, et
- **en ce que** l'on choisit la fréquence médiane du canal de façon à ce que le quotient de la fréquence médiane du canal et de la fréquence d'un signal (20) de référence utilisé pour commander l'oscillateur commandé par la tension soit sensiblement un nombre entier.

10. Circuit (1) PLL qui est conçu pour l'injection d'un signal (34) analogique de modulation et d'un signal (28) numérique de modulation suivant le principe de la modulation à deux points, dans lequel il est monté en parallèle à une voie principale du circuit (1) PLL une voie d'équilibrage,
**caractérisé en ce que**
- la voie d'équilibrage comprend un moyen (14, 15) de sortie de production d'un signal (32) de différence qui est caractéristique de la variation d'un signal (22) de commande d'une unité (9) de production d'une fréquence du circuit (1) PLL lors de l'injection de signaux (28) numériques différents de modulation dans le circuit (1) PLL,
- une unité (19) de comparaison du signal (32) de différence avec un signal (34) de comparaison qui est caractéristique d'une excursion de modulation d'un signal (34) analogique de modulation, et
- une unité (17) de modulation qui modifie l'excursion de modulation du signal (34) analogique de modulation en fonction d'un signal (35) de sortie de l'unité (19) de comparaison.

11. Circuit (1) PLL suivant la revendication 10,
**caractérisé**
- **en ce que** la voie principale du circuit (1) PLL comprend une première pompe (5) de charge et un premier filtre (6) à boucle monté en aval de la première pompe (5) de charge.

12. Circuit (1) PLL suivant la revendication 10 ou 11,
**caractérisé**
- **en ce que** le moyen (14, 15) de sortie comprend une deuxième pompe (14) de charge et un deuxième filtre (15) à boucle monté en aval de la deuxième pompe (14) de charge.

13. Circuit (1) PLL suivant l'une ou plusieurs des revendications 10 à 12,
**caractérisé**
- **en ce que** la voie principale du circuit (1) PLL a une largeur de bande de fréquence plus petite que la voie d'équilibrage, et
- **en ce que** notamment la largeur de bande de filtre à boucle du premier filtre (6) à boucle est plus petite que la largeur de bande de filtre à boucle du deuxième filtre (15) à boucle.

14. Circuit (1) PLL suivant l'une ou plusieurs des revendications 10 à 13,
**caractérisé par**
- un premier commutateur (16) par lequel le signal (32) de différence peut être appliqué à une entrée (33) de modulation d'un oscillateur (7) commandé par la tension du circuit (1) PLL.

15. Circuit (1) PLL suivant l'une ou plusieurs des revendications 10 à 14,
**caractérisé par**
- un deuxième commutateur (18) en la position fermée duquel le signal (34) de comparaison s'applique à une entrée de l'unité (19) de comparaison.
